(19) 

Europäisches
Patentamt

European
Patent Office

Office européen
des brevets

(11) **EP 3 923 359 B1**

(12) **EUROPEAN PATENT SPECIFICATION**

(45) Date of publication and mention
of the grant of the patent:
**17.07.2024 Bulletin 2024/29**

(21) Application number: **20752264.0**

(22) Date of filing: **09.01.2020**

(51) International Patent Classification (IPC):
*B05D 1/26* (2006.01)    *B05D 3/04* (2006.01)
*H10K 71/15* (2023.01)    *B05D 5/12* (2006.01)
*H10K 71/13* (2023.01)    *B05D 7/00* (2006.01)
*B05D 7/04* (2006.01)    *H10K 10/46* (2023.01)

(52) Cooperative Patent Classification (CPC):
**B05D 1/265; B05D 3/0413; B05D 5/12; B05D 7/04;
B05D 7/5423; H10K 71/13; H10K 71/15;**
B05C 5/001; B05C 5/007; B05C 5/0254; B05C 9/06;
B05D 2201/02; B05D 2252/02; B05D 2401/10;
H10K 10/484

(86) International application number:
**PCT/JP2020/000389**

(87) International publication number:
**WO 2020/162093 (13.08.2020 Gazette 2020/33)**

(54) **PRODUCTION METHOD FOR ORGANIC SEMICONDUCTOR THIN FILM**

HERSTELLUNGSVERFAHREN FÜR EINE ORGANISCHE HALBLEITERDÜNNSCHICHT

PROCÉDÉ DE FABRICATION DE FILM MINCE SEMI-CONDUCTEUR ORGANIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.02.2019 JP 2019021818**

(43) Date of publication of application:
**15.12.2021 Bulletin 2021/50**

(73) Proprietor: **FUJIFILM Corporation
Tokyo 106-8620 (JP)**

(72) Inventors:
• **IWASE, Eijiro
Minami-ashigara-shi, Kanagawa 250-0193 (JP)**

• **SUYAMA, Akihiko
Minami-ashigara-shi, Kanagawa 250-0193 (JP)**

(74) Representative: **Meissner Bolte Partnerschaft
mbB
Patentanwälte Rechtsanwälte
Postfach 86 06 24
81633 München (DE)**

(56) References cited:
**WO-A1-2012/023476    WO-A1-2016/143451
JP-A- 2007 095 777    JP-A- 2013 077 799
JP-A- H10 326 023**

• **No further relevant documents disclosed**

**Description**

**BACKGROUND OF THE INVENTION**

1. Field of the Invention

The present invention relates to a method for manufacturing an organic semiconductor thin film.

2. Description of the Related Art

Unlike a conventional inorganic semiconductor, an organic semiconductor is composed of organic molecules that can be dissolved in various solvents, and thus can be formed by coating and printing techniques. Therefore, the organic semiconductor has been studied as a technique for realizing roll-to-roll (hereinafter, also referred to as RtoR) manufacturing of a semiconductor thin film. Various organic semiconductor thin films formed of such an organic semiconductor have been proposed.

However, in general, an organic semiconductor material has a property that the higher the mobility, the poorer the solubility in a solvent. Since the solubility is low, it is extremely difficult to control drying in a case where a solution of the material is applied, and it is difficult to form a uniform crystal film. In addition, productivity is extremely low. Therefore, a technique for forming an organic semiconductor thin film in a large area and at a high speed is required.

With respect to this, a method for precipitating an organic semiconductor thin film using a difference in solubility between a good solvent and a poor solvent has been studied.

For example, JP2012-043926A discloses a method for manufacturing an organic semiconductor thin film, the method including a step of preparing a first ink obtained by dissolving an organic semiconductor at a high concentration in an organic solvent having a high affinity for the organic semiconductor and a second ink composed of an organic solvent having a low affinity for the organic semiconductor, and a step of jetting the first and second inks simultaneously or alternately from each ink head and mixing them on a substrate. According to JP2012-043926A, in this manufacturing method, the first and second inks are mixed on the substrate to precipitate crystals of the organic semiconductor. JP2012-043926A discloses that this manufacturing method enables production of a homogeneous organic semiconductor thin film with extremely few pinholes and of which a film quality and a film thickness are homogeneous including a peripheral portion in a predetermined region. WO2012/023476 discloses a similar method.

JP2012-049291A discloses a method for manufacturing a single crystalline organic semiconductor thin film, the method including a step of preparing a first ink obtained by dissolving an organic semiconductor at a high concentration in an organic solvent having a high affinity for the organic semiconductor and a second ink composed of an organic solvent having a low affinity for the organic semiconductor, and a step of mixing the first and second inks on a substrate and forming a region for storing the ink, in which a shape in which a seed crystal is generated with high efficiency is imparted to a part of the region for storing the ink, and a single crystal is grown over almost the entire region of the region for storing the ink from the shape as a starting point. JP2012-049291A discloses that this manufacturing method enables production of an organic semiconductor layer composed of a unitary single crystal over a wide area of 100 $\mu$m or more $\times$ 100 $\mu$m or more, since a seed crystal is first generated at a portion of an ink liquid droplet stored on the substrate, and this becomes a nucleus to grow a single crystal thin film over the entire region of the liquid droplet.

**SUMMARY OF THE INVENTION**

However, the method disclosed in JP2012-043926A has a problem that it is difficult to form an organic semiconductor thin film having a large area. This is because, a liquid droplet of an ink including an organic semiconductor is jetted by an inkjet, and thus in a case where the liquid droplet is made minute, even though the liquid droplet is jetted continuously to increase the area, a time lag occurs in landing of each liquid droplet on the substrate, and a plurality of mixing portions of the first and second inks are generated in a surface of the substrate, and therefore, the number of triggers for formation of crystal nuclei increases. For this reason, a dot-shaped film is formed, and a uniform crystal film having directionality cannot be formed. On the other hand, in a case where the size of the liquid droplet is increased, a peripheral portion of the liquid droplet tends to be dried more easily than a central portion, and thus, aggregation occurs from the peripheral portion. Therefore, the number of triggers for formation of crystal nuclei also increases. For this reason, a uniform crystal film having directionality cannot be formed.

In the method disclosed in JP2012-049291A, since it is required to form a storage portion on the substrate, and the organic semiconductor thin film is intermittently formed on the substrate, the organic semiconductor thin film cannot be continuously formed, and thus mass production is difficult. In addition, there is a problem that it is necessary to previously form the storage portion having a shape matching the shape of the organic semiconductor thin film to be formed, and it is necessary to form the storage portion for each shape of the organic semiconductor thin film.

An object of the present invention is to solve such a problem, and to provide a method for manufacturing an organic semiconductor thin film which can continuously form an organic semiconductor thin film having a large area and high uniformity, and can easily correspond to various shapes.

The present invention solves the problems by the following configurations.

[1] A method for manufacturing an organic semiconductor thin film, comprising:

a preparation step of preparing a first coating liquid in which an organic semiconductor is dissolved in a first organic solvent and a second coating liquid containing a second organic solvent having a lower affinity for the organic semiconductor than that of the first organic solvent;

a coating step of applying the first coating liquid and the second coating liquid on a substrate in an overlapping manner such that a coating film (12) of the second coating liquid (11) is formed on the substrate (16) and a coating film (14) of the first coating liquid (13) is formed on the coating film (12) of the second coating liquid (11);

a drying step of drying a coating film of the first coating liquid and the second coating liquid applied on the substrate in the coating step after the organic semiconductor is precipitated from the coating film,

wherein, the affinity of the first organic solvent is expressed by a solubility of the first organic solvent with respect to the organic semiconductor, the affinity of the second organic solvent is expressed by a solubility of the second organic solvent with respect to the organic semiconductor, the solubility of the first organic solvent with respect to the organic semiconductor is 0.01wt% or more, and the solubility of the second organic solvent with respect to the organic semiconductor is 0.001wt% or less, and in the coating step, the second coating liquid is in contact with the first coating liquid during a period from jetting of the second coating liquid to application of the second coating liquid on the substrate.

[2] The method for manufacturing an organic semiconductor thin film according to [1], in which a contact angle of the second coating liquid with respect to the substrate is smaller than a contact angle of the first coating liquid with respect to the substrate.

[3] The method for manufacturing an organic semiconductor thin film according to [1] or [2], in which, in the coating step, a temperature of the first coating liquid is higher than a temperature of the second coating liquid.

[4] The method for manufacturing an organic semiconductor thin film according to [3], in which, in the coating step, a temperature of a lip portion that jets the first coating liquid is higher than a temperature of a lip portion that jets the second coating liquid.

[5] The method for manufacturing an organic semiconductor thin film according to [4], in which at least a part of a member between a slot that jets the first coating liquid and a slot that jets the second coating liquid consists of plastic.

[6] The method for manufacturing an organic semiconductor thin film according to any one of [1] to [5], in which, in the coating step, a temperature of the substrate is lower than a temperature of the second coating liquid.

[7] The method for manufacturing an organic semiconductor thin film according to any one of [1] to [6], in which a ratio of a jetting amount of the first coating liquid to a jetting amount of the second coating liquid in the coating step is 1:0.01 to 1:100.

[8] The method for manufacturing an organic semiconductor thin film according to any one of [1] to [7], in which a viscosity of each of the first coating liquid and the second coating liquid in the coating step is 0.0005 Pa·s to 0.05 Pa·s.

[9] The method for manufacturing an organic semiconductor thin film according to any one of [1] to [8], in which the substrate has a long shape, and the coating step and the drying step are performed while the substrate is transported in a longitudinal direction.

[10] The method for manufacturing an organic semiconductor thin film according to [9], in which a transport speed of the substrate is 0.01 m/s to 10 m/s.

According to the present invention, it is possible to provide a method for manufacturing an organic semiconductor thin film which can continuously form an organic semiconductor thin film having a large area and high uniformity, and can easily correspond to various shapes.

## BRIEF DESCRIPTION OF THE DRAWINGS

Fig. 1 is a diagram conceptually showing an example of a manufacturing apparatus that performs a method for manufacturing an organic semiconductor thin film of the present invention.
Fig. 2 is a schematic cross-sectional view showing an enlarged coating portion of Fig. 1.
Fig. 3 is a cross-sectional view schematically showing another example of the coating portion.

Fig. 4 is a cross-sectional view schematically showing another example of the coating portion.
Fig. 5 is a cross-sectional view schematically showing another example of the coating portion.

## DESCRIPTION OF THE PREFERRED EMBODIMENTS

Hereinafter, embodiments of a method for manufacturing an organic semiconductor thin film of the present invention will be described with reference to the drawings. In the drawings of the present specification, the scale of each part is appropriately changed and shown in order to facilitate visual recognition.

In the present specification, a numerical range represented by "to" means a range including numerical values before and after "to" as a lower limit value and an upper limit value.

In the following description, the term "thickness direction" means a direction in which a substrate and a coating film (a coating film of a first coating liquid and a coating film of a second coating liquid), and the like, which will be described below, are arranged (laminated), and the term "thickness" means a length in the thickness direction.

[Method for Manufacturing Organic Semiconductor Thin Film]

The method for manufacturing an organic semiconductor thin film of the embodiment of the present invention includes a preparation step of preparing a first coating liquid in which an organic semiconductor is dissolved in a first organic solvent and a second coating liquid containing a second organic solvent having a lower affinity for the organic semiconductor than that of the first organic solvent, a coating step of applying the first coating liquid and the second coating liquid on a substrate in an overlapping manner in a direction perpendicular to a surface of the substrate, the second coating liquid being applied on a substrate side, and a drying step of drying a coating film of the first coating liquid and the second coating liquid applied on the substrate in the coating step after the organic semiconductor is precipitated from the coating film. In the coating step, the second coating liquid is in contact with the first coating liquid during a period from jetting of the second coating liquid to application of the second coating liquid on the substrate.

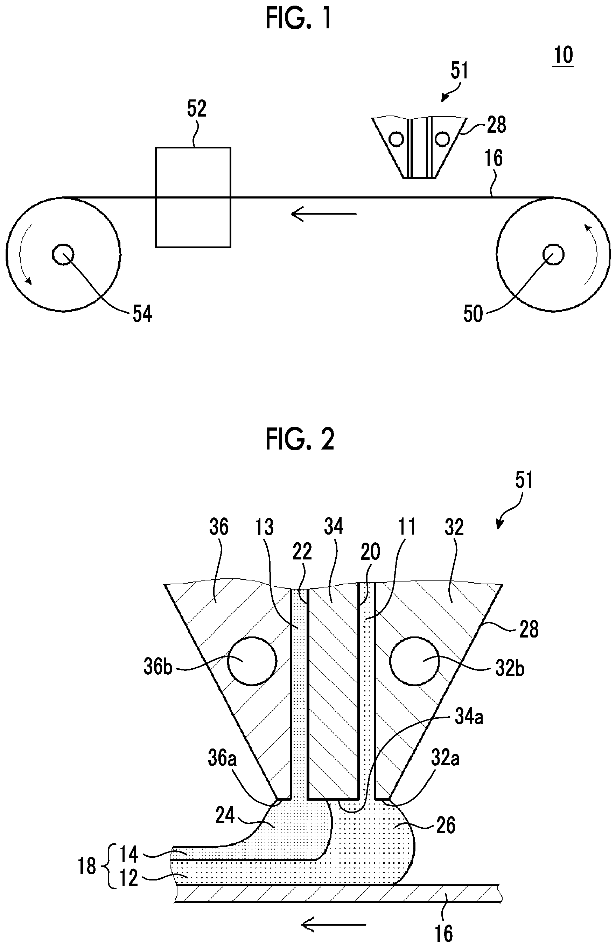

First, an example of an organic semiconductor thin film manufacturing apparatus that performs the method for manufacturing an organic semiconductor thin film of the embodiment of the present invention (hereinafter, also referred to as a manufacturing method of the embodiment of the present invention) will be described with reference to Fig. 1.

An organic semiconductor thin film manufacturing apparatus (hereinafter, also simply referred to as a manufacturing apparatus) 10 shown in Fig. 1 is an apparatus that performs the coating step and the drying step on a long substrate 16 while transporting the substrate 16 in a longitudinal direction by roll-to-roll (hereinafter, also referred to as RtoR).

As is well known, RtoR is a manufacturing method in which a long sheet-like material is fed from a roll formed by winding the sheet-like material and is subjected to film formation while being transported in the longitudinal direction, and the sheet-like material after the film formation is wound into a roll shape. By using RtoR, high productivity and production efficiency can be obtained.

The manufacturing apparatus 10 shown in Fig. 1 has a rotary shaft 50, a coating portion 51, a drying portion 52, and a winding shaft 54.

The rotary shaft 50 is a shaft for rotatably loading a roll formed by winding the long substrate 16.

In a case where a substrate roll 16R is loaded on the rotary shaft 50, the substrate 16 is unwound from the substrate roll 16R and is caused to pass through a predetermined path that extends to the winding shaft 54 through the coating portion 51 and the drying portion 52.

The coating portion 51 is disposed in a transport path of the substrate 16 and performs the coating step on the substrate 16 to be transported.

The coating portion 51 performs so-called simultaneous multilayer coating, in which a first coating liquid 13 and a second coating liquid 11 in which an organic semiconductor is dissolved are applied on the substrate in an overlapping manner in a direction perpendicular to a surface of the substrate 16, the second coating liquid 11 being applied on the substrate 16 side.

The coating portion 51 will be described in detail below with reference to Fig. 2.

Fig. 2 is an enlarged cross-sectional view of the coating portion 51 of the manufacturing apparatus of Fig. 1. Fig. 2 is a cross-sectional view of the coating portion in a direction parallel to a transport direction of the substrate 16.

As shown in Fig. 2, the coating portion 51 has a slot die 28 having two slots (jetting ports) 20 and 22. The slot die 28 jets the second coating liquid 11 and the first coating liquid 13 from the two slots 20 and 22, respectively, and performs simultaneous multilayer coating of the surface of the substrate 16 with the first coating liquid 13 and the second coating liquid 11.

The slot die 28 is composed of three blocks 32, 34, and 36. By combining the three blocks 32, 34, and 36, the slot 20 extending to lip surfaces 32a and 34a which are tip surfaces of the slot die 28 is formed between the block 32 and the block 34, and the slot 22 extending to lip surfaces 34a and 36a which are tip surfaces of the slot die 28 is formed between the block 34 and the block 36.

In addition, the slot 20 and the slot 22 of the slot die 28 extend in a width direction of the substrate 16 (a direction orthogonal to the transport direction (longitudinal direction) of the substrate 16, hereinafter simply referred to as a "width direction").

The second coating liquid 11 is supplied to the slot 20, and the second coating liquid 11 is jetted from a tip (lip portion) of the slot 20.

The first coating liquid 13 is supplied to the slot 22, and the first coating liquid 13 is jetted from a tip (lip portion) of the slot 22.

A pocket for storing the first coating liquid 13 and the second coating liquid 11 may be formed inside the slot die 28.

In the example shown in Fig. 2, as a preferred aspect, temperature adjusting holes 32b and 36b are formed in the block 32 and the block 36 of the slot die 28, respectively.

The slot die 28 is disposed such that a clearance between the lip surface (32a, 34a, 36a), which is the tip surface of the slot die 28, and the substrate 16 is a predetermined distance.

The clearance between the lip surface (32a, 34a, 36a) of the slot die 28 and the substrate 16 is preferably 1 $\mu$m to 500 $\mu$m, more preferably 10 $\mu$m to 300 $\mu$m, and still more preferably 30 $\mu$m to 200 $\mu$m.

By setting the clearance within the above range, the coating can be stably performed with a uniform thickness.

In the manufacturing apparatus 10, the drying portion 52 is disposed on a downstream side of the coating portion 51.

The drying portion 52 is a portion that dries coating films of the first coating liquid 13 and the second coating liquid 11 applied on the substrate 16.

The drying portion 52 need only have a known drying device according to a method for drying the coating film in the drying step. For example, in a case where hot air drying is performed, the drying portion 52 has a known hot air drying device.

In the manufacturing apparatus 10, the winding shaft 54 is disposed on a downstream side of the drying portion 52.

The winding shaft 54 is a shaft for winding the long substrate 16 on which the organic semiconductor thin film is formed into a roll shape.

In addition, the winding shaft 54 may be attached to an electric motor and have a function as a part of a transport device that transports the substrate 16.

Next, each step of the method for manufacturing an organic semiconductor thin film of the embodiment of the present invention will be described.

<Preparation Step>

The preparation step is a step of preparing the first coating liquid 13 and the second coating liquid 11 to be used in the coating step.

The first coating liquid 13 is a coating liquid obtained by dissolving an organic semiconductor in a first organic solvent capable of dissolving the organic semiconductor. The first organic solvent is a good solvent.

The second coating liquid 11 is a coating liquid containing a second organic solvent having a lower affinity for the organic semiconductor than that of the first organic solvent. The second organic solvent is a poor solvent.

The affinity for the organic semiconductor can be expressed by the solubility of the organic semiconductor.

The solubility of the first organic solvent to the organic semiconductor is 0.01 wt% or more, preferably 0.05 wt% or more, and more preferably 0.1 wt% or more.

The solubility of the second organic solvent to the organic semiconductor is 0.001 wt% or less, preferably 0.0001 wt% or less, and more preferably 0.00001 wt% or less.

The first coating liquid 13 and the second coating liquid 11 need only be prepared by a known method depending on the organic semiconductor and the organic solvent used.

In addition, the first coating liquid 13 and the second coating liquid 11 may contain a thickener, a crystallization agent, an antioxidant, a surfactant, and the like, in addition to the organic semiconductor and the organic solvent, as necessary.

(Organic Semiconductor)

Examples of the organic semiconductor include an organic polymer and a derivative thereof, and a low molecular weight compound, which exhibit semiconductivity.

In the present invention, the low molecular weight compound means a compound other than an organic polymer and a derivative thereof. That is, it refers to a compound having no repeating unit. A molecular weight of the low molecular weight compound is not particularly limited as long as it is such a compound. The molecular weight of the low molecular weight compound is preferably 300 to 2000, and more preferably 400 to 1000.

Specifically, examples of the organic semiconductor include a pentacene derivative such as 6,13-bis(triisopropylsilylethynyl)pentacene (TIPS pentacene), an anthradithiophene derivative such as 5,11-bis(triethylsilylethynyl)anthradithiophene (TES-ADT), a benzodithiophene (BDT) derivative, a benzothienobenzothiophene (BTBT) derivative such as dioctylbenzothienobenzothiophene (C8-BTBT), a dinaphthothienothiophene (DNTT) derivative, a dinaphthobenzodithiophene (DNBDT) derivative, a 6,12-dioxaanthanthrene (perixanthenoxanthene) derivative, a naphthalene tetracarboxylic acid diimide (NTCDI) derivative, a perylene tetracarboxylic acid diimide (PTCDI) derivative, a polythiophene derivative, a poly(2,5-bis(thiophene-2-yl)thieno[3,2-b]thiophene) (PBTTT) derivative, a tetracyanoquinodimethane (TCNQ) derivative, oligothiophenes, phthalocyanines, and fullerenes.

As the organic semiconductor, the materials disclosed in paragraphs [0063] to [0160] of JP2015-170760A are also exemplified. Further, as the organic semiconductor, the organic semiconductor disclosed in JP2015-195361A and the organic semiconductor disclosed in JP2018-006745A are also exemplified.

(First Organic Solvent)

As the first organic solvent, an organic solvent having a high solubility to the organic semiconductor need only be selected depending on the material of the organic semiconductor. For example, in a case where the organic semiconductor is TIPS pentacene, TES-ADT, or the like, an aromatic compound such as toluene, xylene, mesitylene, 1,2,3,4-tetrahydronaphthalene (tetralin), chlorobenzene, dichlorobenzene, and anisole is suitably exemplified as the first organic solvent.

(Second Organic Solvent)

As the second organic solvent, an organic solvent having a low solubility to the organic semiconductor need only be selected depending on the material of the organic semiconductor. For example, in a case where the organic semiconductor is TIPS pentacene, TES-ADT, or the like, methyl ethyl ketone, N,N-dimethylformamide, methyl isobutyl ketone (MIBK), acetone, and the like are exemplified as the second organic solvent.

<Coating Step>

In the coating step, the first coating liquid 13 and the second coating liquid 11 prepared in the above preparation step are applied (simultaneous multilayer coating) on the substrate 16 in an overlapping manner in a direction perpendicular to a surface of the substrate 16, the second coating liquid 11 being applied on the substrate 16 side.

As an example, the coating step is performed using the manufacturing apparatus 10 described above.

After setting the first coating liquid 13 and the second coating liquid 11 to be supplied to the slot die 28 by causing the long substrate 16 to pass through a predetermined transport path extending from the rotary shaft 50 to the winding shaft 54 of the manufacturing apparatus 10 shown in Fig. 1, transport of the substrate 16 is started, and jetting of the second coating liquid 11 and the first coating liquid 13 from the slots 20 and 22 of the slot die 28 is started, and then, the coating films of the second coating liquid 11 and the first coating liquid 13 are formed on the substrate 16 to be transported.

As shown in Fig. 2, the second coating liquid 11 is supplied to the slot 20 on an upstream side in the transport direction of the substrate 16 (hereinafter, also simply referred to as an "upstream side"). In addition, the first coating liquid 13 is supplied to the slot 22 on a downstream side in the transport direction of the substrate 16 (hereinafter, also simply referred to as a "downstream side").

Therefore, the second coating liquid 11 is laminated on the substrate 16, and the first coating liquid 13 is laminated on the second coating liquid 11.

(Substrate)

Examples of the substrate 16 include a silicon wafer; a resin film such as a polyethylene naphthalate (PEN) film; a glass substrate; and a metal film.

As the substrate 16, it is preferable to use a material having a high wettability (a low contact angle) of the second coating liquid 11. In addition, a surface treatment may be performed so that the wettability of the second coating liquid 11 is increased.

A conventionally known surface treatment performed on a surface on which an organic semiconductor such as a self-assemble monolayer (SAM) is formed can also be performed on the surface of the substrate 16. Thus, an organic semiconductor thin film having high crystallinity is easily formed.

In addition, a substrate having a gate electrode, an insulating film, or the like formed on a base material may be used.

Here, in the present invention, in the coating step, the second coating liquid 11 is in contact with the first coating liquid 13 during a period from jetting of the second coating liquid 11 to application of the second coating liquid 11 on the substrate 16. That is, the application of the second coating liquid 11 and the application of the first coating liquid 13 are performed almost simultaneously.

As shown in Fig. 2, the second coating liquid 11 jetted from the tip (lip portion) of the slot 20 forms a bead 26 at a clearance position between the slot die 28 and the substrate 16. In addition, the bead 26 of the second coating liquid 11 has a shape of wetting and spreading on a part of the lip surface 32a of the block 32 and the lip surface 34a of the block 34.

Similarly, the first coating liquid 13 jetted from the tip (lip portion) of the slot 22 forms a bead 24 at a clearance position between the slot die 28 and the substrate 16. In addition, the bead 24 of the first coating liquid 13 has a shape of wetting and spreading on a part of the lip surface 34a of the block 34 and the lip surface 36a of the block 36.

As shown in Fig. 2, the bead 24 of the first coating liquid 13 and the bead 26 of the second coating liquid 11 are in contact with each other from the position of the lip surface 34a to the substrate. Therefore, there is no gas-liquid interface on a surface of the bead 24 of the first coating liquid 13 on a side of the second coating liquid 11.

The first coating liquid 13 and the second coating liquid 11 applied on the substrate 16 are transported together with the substrate 16 in a state where a coating film 12 of the second coating liquid 11 is formed on the substrate 16 side and a coating film 14 of the first coating liquid 13 is formed on the coating film 12 of the second coating liquid 11.

The first organic solvent in the coating film 14 of the first coating liquid 13 and the second organic solvent in the coating film 12 of the second coating liquid 11 are mixed over time because of a high affinity therebetween. Then, the organic semiconductor is easily precipitated in a coating film 18 in which the first coating liquid 13 and the second coating liquid 11 are mixed. That is, the more downstream from the coating portion 51, the more the first organic solvent and the second organic solvent are mixed, and the organic semiconductor is easily precipitated.

Therefore, in a case where crystal nuclei are generated at a certain position of the coating film 18 and precipitation of the crystal of the organic semiconductor is started, a single crystal is grown (precipitate) around the crystal nuclei. Since the first coating liquid 13 and the second coating liquid 11 are continuously applied (supplied) by the coating portion 51 while the coating film 18 is transported together with the substrate 16, the single crystal continues to precipitate (grown) on the upstream side, and continuously connected crystals are precipitated.

<Drying Step>

In the drying step, the coating film 18 is dried after the organic semiconductor is precipitated from the coating film 18 of the first coating liquid 13 and the second coating liquid 11 applied on the substrate 16.

In the example shown in Fig. 1, the drying step is performed by the drying portion 52 disposed on the downstream side of the coating portion 51.

As a drying method, a known drying method such as hot air drying and heat drying can be appropriately used.

Since the drying step is performed after the organic semiconductor is precipitated from the coating film 18, a disposition position of the drying portion 52 in the transport direction of the substrate 16 need only be set according to a timing (position) at which the organic semiconductor is precipitated.

By the above steps, an organic semiconductor thin film is produced.

Here, as described above, in a method of simultaneously or alternately jetting, from each ink head, a first ink obtained by dissolving an organic semiconductor in an organic solvent having a high affinity for the organic semiconductor and a second ink composed of an organic solvent having a low affinity for the organic semiconductor and mixing them on a substrate, a liquid droplet of the ink is jetted by an inkjet, and thus in a case where the liquid droplet is made minute, even though the liquid droplet is jetted continuously to increase the area, a time lag occurs in landing of each liquid droplet on the substrate, and a plurality of mixing portions of the first and second inks are generated in a surface of the substrate. Therefore, the number of triggers for formation of crystal nuclei increases, and, for this reason, a dot-shaped film is formed, and a uniform crystal film having directionality cannot be formed. In addition, even in a case where the size of the liquid droplet is increased, a peripheral portion of the liquid droplet tends to be dried more easily than a central portion, and thus, aggregation occurs from the peripheral portion. Therefore, the number of triggers for formation of crystal nuclei also increases, and a uniform crystal film having directionality cannot be formed.

In addition, in a method of forming a region for storing an ink on a substrate and growing a single crystal thin film over the entire region of a liquid droplet with a seed crystal first generated at a portion of the ink liquid droplet stored in the region as a nucleus, it is required to form a storage portion on the substrate, and the organic semiconductor thin film is intermittently formed on the substrate. Therefore, the organic semiconductor thin film cannot be continuously formed, and mass production is difficult. In addition, there is a problem that it is necessary to previously form the storage portion having a shape matching the shape of the organic semiconductor thin film to be formed, and it is necessary to form the storage portion for each shape of the organic semiconductor thin film.

With respect to this, in the manufacturing method of the embodiment of the present invention, the first coating liquid in which the organic semiconductor is dissolved and the second coating liquid having a low affinity for the organic semiconductor are applied on the substrate by simultaneous multilayer coating. As a result, the first coating liquid and the second coating liquid can be continuously supplied to the crystals of the precipitated organic semiconductor to form continuously connected crystals. In addition, by disposing a plurality of the slot dies 28 in the width direction of the substrate 16, the length of the organic semiconductor film in the width direction can be increased. Therefore, it is possible to continuously form an organic semiconductor thin film having a large area and high uniformity.

Here, in the manufacturing method of the embodiment of the present invention, the second coating liquid 11 is in contact with the first coating liquid 13 during the period from the jetting of the second coating liquid 11 to the application of the second coating liquid 11 on the substrate 16. Therefore, during a period from the jetting of the first coating liquid 13 to the application of the first coating liquid 13 on the substrate 16, the surface of the bead 24 of the first coating liquid 13 on the second coating liquid 11 side is in contact with the second coating liquid 11, and there is no gas-liquid interface.

In a case where there is a gas-liquid interface on the surface of the bead 24 of the first coating liquid 13 on the second coating liquid 11 side, that is, the bead 24 of the first coating liquid 13 and the bead 26 of the second coating liquid 11 are not in contact with each other, an area of the gas-liquid interface of the bead 24 of the first coating liquid 13 is increased. Therefore, the first organic solvent in the first coating liquid 13 tends to evaporate easily, and crystal nuclei may be generated at the position of the bead 24 or the like. That is, there is a possibility that the number of triggers for formation of crystal nuclei increases, and a uniform crystal film having directionality cannot be formed.

With respect to this, in the present invention, in a case where the surface of the bead 24 of the first coating liquid 13 on the second coating liquid 11 side is in contact with the second coating liquid 11, generation of the crystal nuclei at the position of the bead 24 or the like is suppressed, and a uniform crystal film having directionality can be formed.

In the manufacturing method of the embodiment of the present invention, the length of the organic semiconductor film in the transport direction of the substrate 16 can be adjusted by adjusting jetting times of the first coating liquid 13 and the second coating liquid 11. In addition, the length of the organic semiconductor film in the width direction of the substrate 16 can be adjusted by the width, number, and the like of the slot die. Therefore, it is possible to easily correspond to various shapes and sizes.

Here, it is preferable that a contact angle of the second coating liquid 11 with respect to the substrate 16 is smaller than a contact angle of the first coating liquid 13 with respect to the substrate 16. That is, it is preferable that the second coating liquid 11 has a high wettability with respect to the substrate 16. In a case where the wettability of the second coating liquid 11 with respect to the substrate 16 is high, the second coating liquid 11 wets and spreads on the surface of the substrate 16 after application, and the first coating liquid 13 also spreads along with the second coating liquid 11. Therefore, the organic semiconductor thin film having no large defect can be suitably formed.

The contact angle of the second coating liquid 11 with respect to the substrate 16 is preferably 50° or less, more preferably 40° or less, and still more preferably 20° or less.

A viscosity of each of the first coating liquid 13 and the second coating liquid 11 is preferably 0.005 Pa s to 0.1 Pa·s, more preferably 0.007 Pa·s to 0.05 Pa·s, and still more preferably 0.008 Pa·s to 0.01 Pa·s.

By setting the viscosities of the first coating liquid 13 and the second coating liquid 11 within this range, the first coating liquid 13 and the second coating liquid 11 can be uniformly applied on the substrate 16.

Here, in the coating step, it is preferable that a temperature of the first coating liquid 13 is higher than a temperature of the second coating liquid 11.

By raising the temperature of the first coating liquid 13, the solubility of the organic semiconductor can be increased. In a case where the solubility of the organic semiconductor in the first coating liquid 13 can be increased, a thickness of the coating film can be reduced in a case of forming an organic semiconductor thin film having the same film thickness. Therefore, a coating speed, that is, the transport speed of the substrate can be made high to improve productivity.

In addition, it is preferable that the temperature of the first coating liquid 13 is made higher than the temperature of the second coating liquid 11 so that the temperature of the first coating liquid 13 is lowered after the first coating liquid 13 and the second coating liquid 11 are applied on the substrate 16, and the organic semiconductor is easily precipitated.

From the above viewpoint, the temperature of the first coating liquid 13 to the coating step after the preparation is preferably 20°C to 120°C, more preferably 25°C to 100°C, and still more preferably 30°C to 90°C.

In addition, the temperature of the second coating liquid 11 during the coating step is preferably 1°C to 100°C, more preferably 5°C to 70°C, and still more preferably 10°C to 60°C.

From the above viewpoint, it is preferable to maintain the above temperature range until immediately before the first coating liquid 13 and the second coating liquid 11 are applied to the substrate 16. Therefore, in the coating step, it is preferable that a temperature of the lip portion of the slot die 28 that jets the first coating liquid 13 and a temperature of the lip portion of the slot die 28 that jets the second coating liquid 11 are respectively adjusted. That is, it is preferable that the temperature of the lip portion that jets the first coating liquid 13 is adjusted so as to be higher than the temperature of the lip portion that jets the second coating liquid 11.

In the example shown in Fig. 2, the block 32 and the block 36 of the slot die 28 have the temperature adjusting hole 32b and the temperature adjusting hole 36b, respectively, and a rod-shaped heater is inserted into the temperature adjusting hole 32b and the temperature adjusting hole 36b to adjust the temperatures of the block 32 and the block 36, respectively.

In the case of the example shown in Fig. 2, at least a part of a member between the slot 22 that jets the first coating liquid 13 and the slot 20 that jets the second coating liquid 11 is preferably made of plastic having low thermal conductivity. That is, the block 34 is preferably made of a material having lower thermal conductivity than the block 32 and the block 36.

From the viewpoint of temperature adjustment, the block 32 and the block 36 are preferably made of a metal having high thermal conductivity. On the other hand, in a case where the thermal conductivity of the block 34 between the slot 22 and the slot 20 is high, it is difficult to maintain a temperature difference between the block 32 and the block 36. Therefore, by using a plastic material having low thermal conductivity as the material of the block 34, the temperature difference between the block 32 and the block 36, that is, the temperature of the lip portion that jets the first coating liquid 13 and the temperature of the lip portion that jets the second coating liquid 11 can be maintained.

In addition, in the coating step, it is preferable that a temperature of the substrate 16 is lower than the temperature of the second coating liquid 11. By making the temperature of the substrate 16 lower than the temperature of the second coating liquid 11, the precipitation of the crystals of the organic semiconductor can be made faster.

In order to adjust the temperature of the substrate 16, the manufacturing apparatus 10 may have a temperature adjusting portion of the substrate 16. The temperature adjusting method of the substrate 16 is not particularly limited, and a known temperature adjusting method can be appropriately used.

The temperature of the substrate 16 during the coating step is preferably 1°C to 120°C, more preferably 5°C to 100°C, and still more preferably 15°C to 90°C.

In addition, in the drying step, in a case of heat drying and hot air drying, the drying temperature is preferably higher than the temperature of the first coating liquid 13. As a result, the organic semiconductor can be quickly dried after crystal precipitation.

A thickness of the coating film 14 of the first coating liquid 13 and a thickness of the coating film 12 of the second coating liquid 11 immediately after the application need only be appropriately set according to the thickness of the organic semiconductor thin film to be produced, the type of the organic semiconductor, the type of the first organic solvent, the solubility of the organic semiconductor, the type of the second organic solvent, and the like.

A ratio of the thickness of the coating film 14 of the first coating liquid 13 to the thickness of the coating film 12 of the second coating liquid 11 immediately after the application is preferably 1:0.01 to 1:100, more preferably 1:0.1 to 1:10, and still more preferably 1:0.2 to 1:5.

A jetting amount of the first coating liquid 13 and a jetting amount of the second coating liquid 11 in the coating step need only be appropriately set according to the thickness of the coating film 14 of the first coating liquid 13, the thickness of the coating film 12 of the second coating liquid 11, the transport speed of the substrate 16, and the like.

A ratio of the jetting amount of the first coating liquid 13 to the jetting amount of the second coating liquid 11 is substantially the same as the ratio of the thickness of the coating film.

A width of the slot 20 and a width of the slot 22 in the transport direction of the substrate 16 need only be appropriately set according to the jetting amount of the first coating liquid 13, the jetting of the second coating liquid 11, and the like.

The transport speed of the substrate 16 is not particularly limited as long as it is capable of producing an organic semiconductor thin film having a desired thickness, and is preferably 0.01 m/s to 10 m/s.

As shown in Fig. 2, in a case where the coating liquid is jetted from the slot die to perform coating, a support member may be provided to support a back surface side (the surface opposite to the slot die) of the substrate.

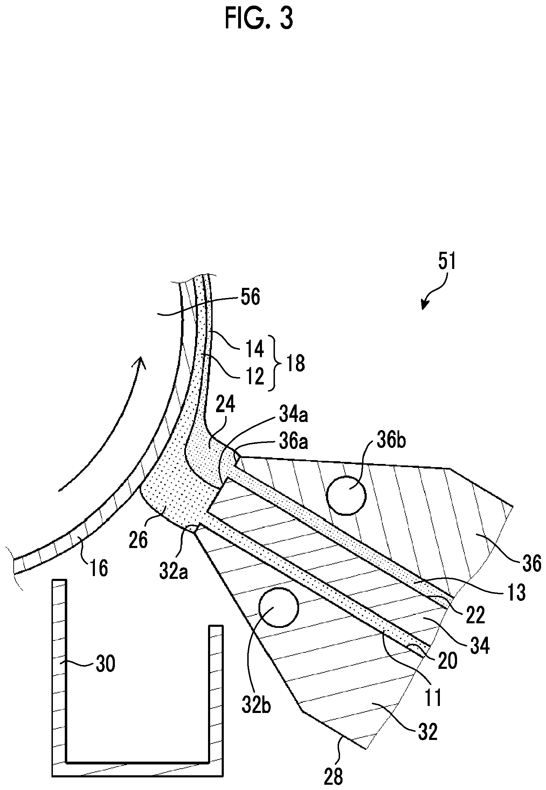

For example, in the example shown in Fig. 3, the coating portion 51 has a backup roller 56 at a position facing the lip surface (32a, 34a, 36a) of the slot die 28. The backup roller 56 is disposed such that a peripheral surface thereof faces the lip surface (32a, 34a, 36a) of the slot die 28, and the substrate 16 is wound around the peripheral surface to rotate.

In the example shown in Fig. 3, coating is performed while the substrate 16 is supported by the backup roller 56. With such a configuration, the clearance between the lip surface (32a, 34a, 36a) of the slot die 28 and the surface of the substrate 16 can be kept constant.

In addition, in the example shown in Fig. 3, a cover 30 that covers an upstream side of the slot die 28 is provided. The inside of the cover 30 is sucked by a vacuum pump (not shown) to decompress the inside of the cover 30. As a result, the bead is stabilized by balancing a force with which the upstream side of the bead is pulled and a force with which the coating liquid is carried by the transport of the substrate 16.

In Fig. 3, the configuration of the slot die 28 has the same configuration as that of the slot die 28 shown in Fig. 2, and thus the description thereof will be omitted. This point is the same in the following description.

In addition, the clearance between the lip surface of the slot die and the surface of the substrate may be kept constant by applying a tension to the substrate at a position where the coating liquid is jetted from the slot die to perform coating.

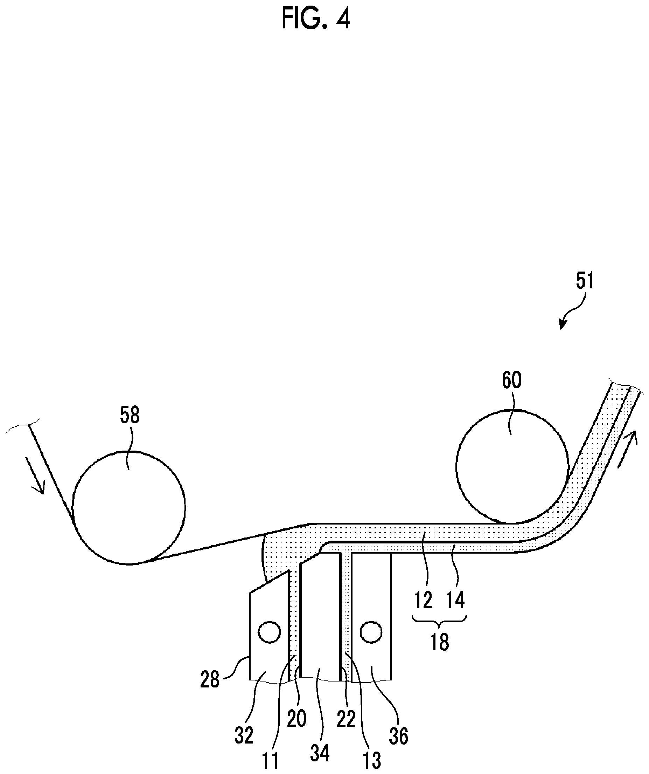

For example, in the example shown in Fig. 4, tension rollers 58 and 60 disposed on the upstream side and the downstream side with the slot die 28 interposed therebetween are provided. The substrate 16 is wound around peripheral surfaces of the tension rollers 58 and 60. A tension by the two tension rollers 58 and 60 and a pressing force by the coating liquid jetted from the slot die 28 are applied to the substrate 16, and these forces are balanced. As a result, the clearance between the lip surface of the slot die and the surface of the substrate can be suitably kept constant.

In the example shown in Fig. 2, the slot die 28 has a configuration in which the clearance with the substrate 16 at the position of the slot 22 that jets the first coating liquid 13 and the clearance with the substrate 16 at the position of the slot 20 that jets the second coating liquid 11 are substantially the same, and the slot die 28 jets the first coating liquid 13 and the second coating liquid 11 almost simultaneously, but the configuration is not limited this. That is, the coating method in the coating step is not limited to simultaneous multilayer coating.

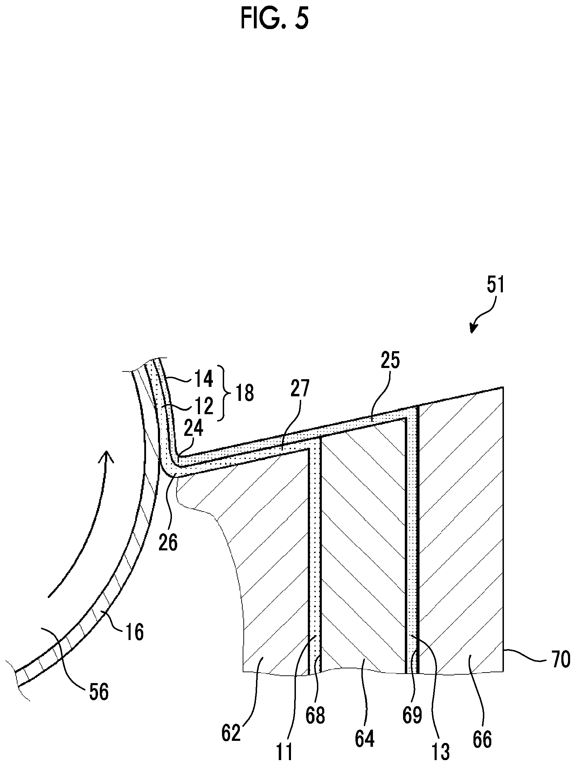

For example, as in the example shown in Fig. 5, the coating method in the coating step may be multilayer slide bead coating.

The coating portion 51 shown in Fig. 5 has a slide hopper 70 that performs the slide bead coating.

The slide hopper 70 has three blocks 62, 64, and 66, and the three blocks 62, 64, and 66 are combined to form a slot 68 between the block 62 and the block 34 and a slot 69 between the block 64 and the block 66.

In addition, the three blocks 62, 64, and 66 are arranged in a direction perpendicular to the surface of the substrate. Therefore, a jetting port of the slot 69 is disposed farther from the substrate than a jetting port of the slot 68.

Surfaces of the block 62 and the block 64 on the jetting port side of the slots (68, 69) are slide surfaces, and serve as flow paths for the coating liquid.

The second coating liquid 11 is supplied to the slot 68, jetted on the slide surface side, and flows down on the slide surface of the block 62 (reference numeral 27 in Fig. 5). The first coating liquid 13 is supplied to the slot 69, jetted on the slide surface side and flows down on the slide surface of the block 64 (reference numeral 25 in Fig. 5), and then flows down on the slide surface of the block 62 in layers on the second coating liquid 11 (27). The first coating liquid 13 and the second coating liquid 11 that have flowed down on the slide surfaces reach a tip of the block 62 on the substrate 16 side. The first coating liquid 13 and the second coating liquid 11 that have reached the tip of the block 62 form a bead between the tip of the block 62 and the substrate 16, and are applied to the substrate 16 through the bead.

Even in such a configuration in which the multilayer slide bead coating is performed, the second coating liquid 11 is in contact with the first coating liquid 13 during a period from jetting of the second coating liquid 11 to application of the second coating liquid 11 on the substrate 16. In addition, the surface of the bead 24 of the first coating liquid 13 on the second coating liquid 11 side is in contact with the slide surface of the block 64 after the first coating liquid 13 is jetted from the slot 69, and the first coating liquid 13 is applied to the substrate 16 in a state of being in contact with the second coating liquid 11 after flowing down on the slide surface.

Therefore, even in the case of a configuration in which the multilayer slide bead coating is performed in the coating step, the surface of the bead of the first coating liquid on the second coating liquid side is in contact with the slide surface of the block 64 or the second coating liquid 11 during a period from the jetting of the first coating liquid to the application of the first coating liquid on the substrate. As a result, it is possible to suppress generation of the crystal nuclei at the position of the bead 24 or the like, and to form a uniform crystal film having directionality.

Further, in the method for manufacturing an organic semiconductor thin film performed by the manufacturing apparatus shown in Fig. 1, each step is performed by roll-to-roll (RtoR), but may be performed by a batch method using a cut substrate. In a case where the manufacturing method of the embodiment of the present invention is performed by a batch method, the coating step may be configured such that coating is performed while fixing the coating portion (slot die) and moving the substrate, or may be configured such that coating is performed while fixing the substrate and moving the coating portion (slot die).

Although the method for manufacturing an organic semiconductor thin film of the embodiment of the present invention has been described above in detail, the present invention is not limited to the above-described embodiments, and various improvements and changes may be made without departing from the scope of the present invention.

Examples

Hereinafter, the present invention will be described more specifically with reference to Examples. The present invention is not limited to the specific examples shown below.

[Example 1]

<Preparation Step>

(First Coating Liquid)

TIPS pentacene (manufactured by Sigma-Aldrich) was used as the organic semiconductor. Dichloromethane was used as the first organic solvent.

Dichloromethane was heated to 40°C to dissolve TIPS pentacene at 5 wt% to prepare the first coating liquid.

A syringe pump was filled with the prepared first coating liquid and connected to a slot on a downstream side of a slot die including two slots described below by a silicon tube. The temperature of the first coating liquid was maintained at 40°C by heating the syringe pump and the silicon tube by a ribbon heater.

(Second Coating Liquid)

Dimethylformamide was used as the second organic solvent. This dimethylformamide was used as the second coating liquid.

A syringe pump was filled with this second coating liquid and connected to a slot on an upstream side of a slot die including two slots described below by a silicon tube. The temperature of the second coating liquid was maintained at 25°C by heating the syringe pump and the silicon tube by a ribbon heater.

<Substrate>

The following substrate was prepared.

As a base material, a PEN film having a thickness of 100 $\mu$m and a size of 100 mm $\times$ 500 mm (Q65 manufactured by Teijin Limited, uncoated) was used.

The PEN film was masked and gold was vapor-deposited by sputtering to form a gate electrode. The gate electrode had a size of 10 mm $\times$ 2 mm and a thickness of 50 nm.

An $SiO_2$ film was formed as an insulating film on the base material on which the gate electrode was formed by using a sputtering device. The insulating film had a size of 50 mm $\times$ 50 mm and a thickness of 50 nm.

In order to control the contact angle on the surface of the insulating film, an SAM film was formed on the insulating film as follows.

The base material having the insulating film formed thereon and a vial bottle (3 ml) containing 1 ml of trimethoxy(2-phenylethyl)silane were put into an oven at 130°C and heated for 3 hours. The trimethoxy(2-phenylethyl)silane in the bottle evaporated to form an SAM film on the insulating film.

In order to remove the excess SAM film, toluene was put into an ultrasonic cleaning device 1, and the base material in which the SAM film was formed was immersed therein and cleaned for 5 minutes. Further, isopropyl alcohol (IPA) was put into an ultrasonic cleaning device 2, and the base material was cleaned and rinsed for 5 minutes. The base material was dried by a dryer for about 3 minutes to remove a rinse liquid.

From the above, a substrate having a gate electrode, an insulating film, and an SAM film was obtained. The contact angle of the substrate having the SAM film formed thereon was confirmed to be 70° using a contact angle meter.

<Slot Die>

A slot die including three blocks and having two slots was prepared as the slot die. A width of the slot die was 35 mm, and a height in the direction perpendicular to the surface of the substrate was 40 mm. A length of each slot in the transport direction of the substrate was 0.2 mm (200 $\mu$m). A gap between the two slots (a length of an intermediate block) was 2 mm.

In addition, the blocks on both sides had temperature adjusting holes.

A material of the blocks on both sides was SUS304, and a material of the intermediate block was a polyetheretherketone (PEEK) resin.

<Coating Step>

The substrate was placed on a hot plate and heated to 25 degrees. In addition, the slot die was installed above the substrate. A clearance between the substrate and the slot die was 50 $\mu$m.

The hot plate was placed on an X stage manufactured by Chuo-Seiki Co., Ltd. and could be moved with respect to the slot die at any speed. A moving speed was controlled to be 10 mm/s.

The second coating liquid was supplied to the slot on the upstream side of the slot die, and the first coating liquid was supplied to the slot on the downstream side. A rod-shaped heater was inserted into the temperature adjusting hole of the block on the upstream side (hereinafter referred to as a block B) to adjust the temperature, and the temperature of the block B was set to 25°C. In addition, a rod-shaped heater was inserted into the temperature adjusting hole of the block on the downstream side (hereinafter referred to as a block A) to adjust the temperature, and the temperature of the block A was set to 40°C.

The second coating liquid was fed from the slot on the upstream side, and simultaneously, the first coating liquid was fed from the slot on the downstream side, and the second coating liquid and the first coating liquid were applied on the substrate in an overlapping manner while moving the substrate, the second coating liquid being applied on the substrate side.

The first coating liquid was fed by a microsyringe so that a wet film thickness was 2 $\mu$m (dry thickness of 100 nm). The second coating liquid was fed by a microsyringe so that a wet film thickness was 10 $\mu$m.

<Drying Step>

After the coating step, precipitation of the organic semiconductor was confirmed, and a laminate of the coating film and the substrate was heated in an oven at 150°C for 3 minutes and dried.

By the above steps, an organic semiconductor thin film was formed on the substrate.

[Example 2]

An organic semiconductor thin film was formed in the same manner as in Example 1 except that the temperature of the first coating liquid was 80°C, the temperature of the block A was 80°C, the temperature of the second coating liquid was 25°C, and the temperature of the block B was 25°C.

[Example 3]

An organic semiconductor thin film was formed in the same manner as in Example 1 except that the temperature of the first coating liquid was 30°C, the temperature of the block A was 30°C, the temperature of the second coating liquid was 25°C, and the temperature of the block B was 25°C.

[Example 4]

An organic semiconductor thin film was formed in the same manner as in Example 1 except that the temperature of the first coating liquid was 40°C, the temperature of the block A was 40°C, the temperature of the second coating liquid was 60°C, and the temperature of the block B was 60°C.

[Example 5]

An organic semiconductor thin film was formed in the same manner as in Example 1 except that the first coating liquid was prepared to be 5 wt% at 40°C by using C8-BTBT (manufactured by Sigma-Aldrich) as the organic semiconductor of the first coating liquid and toluene as the first organic solvent, and methyl ethyl ketone (MEK) was used as the second coating liquid (second organic solvent).

[Comparative Example 1]

Two slot dies with one slot were prepared, the second coating liquid was applied on the substrate with the first slot die, and then the first coating liquid was applied on the second coating liquid with the other slot die. That is, during a period from the jetting of the first coating liquid to the application of the first coating liquid on the substrate, the coating was performed in a state where the gas-liquid interface was present on the surface of the bead of the first coating liquid on the second coating liquid side.

The configuration of the slot die was the same as that of the slot die used in Example 1 except that there was only one slot.

[Comparative Example 2]

An organic semiconductor thin film was formed in the same manner as in Example 1 except that dichloromethane was used as the second coating liquid (second organic solvent).

[Example 6]

In the coating step, an organic semiconductor thin film was formed in the same manner as in Example 1 except that the multilayer slide bead coating was performed using the slide hopper 70 as shown in Fig. 5.

The slide hopper was composed of three blocks. A length of the slide surface of the block on the substrate side was 1 mm, and a length of the slide surface of the intermediate block was 1 mm. A width of the slot was 200 $\mu$m.

In addition, a clearance between the slide hopper and the substrate was 50 $\mu$m.

[Evaluation]

<Uniformity>

A crystal film of the formed organic semiconductor thin film was observed by a differential interference microscope to observe the uniformity of the film and formation of aggregates. At randomly selected five locations in a field of view of 1 mm square of the microscope, a state in which a single uniform crystal was formed was evaluated as A, a state in which a majority was a uniform continuous film was evaluated as B, a state in which a part was a uniform film was evaluated as C, a state in which intermittent connection was formed was evaluated as D, and a state in which aggregates were scattered was evaluated as E.

<Film Thickness>

A step on an edge portion of the organic semiconductor thin film was measured by an atomic force microscope (AFM) and used as the film thickness.

<Mobility of Organic Thin Film Transistor>

A source electrode and a drain electrode were formed on the formed organic semiconductor thin film as described below to produce an organic thin film transistor, and the mobility was measured and evaluated.

A mask was placed on the organic semiconductor thin film, and a copper electrode was formed by vacuum deposition.

The source electrode and the drain electrode had a size of 10 mm $\times$ 5 mm and a thickness of 50 nm, a distance (channel length) between the source electrode and the drain electrode was 30 $\mu$m.

The mobility (carrier mobility) was evaluated by the following method.

A voltage of -40V was applied between the source electrode and the drain electrode, a gate voltage was changed in a range of 40 V to -40V, and the carrier mobility $\mu$ was calculated using the following equation representing a drain current Id.

$$Id = (w/2L)\mu Ci(Vg\text{-}Vth)^2$$

(In the equation, L is a gate length, w is a gate width, Ci is a capacity per unit area of an insulating layer, Vg is a gate voltage, and Vth is a threshold voltage).

The results are shown in the table below.

[Table 1]

Table 1

| | First coating liquid | | | | Second coating liquid | | Coating method | Evaluation | | |
|---|---|---|---|---|---|---|---|---|---|---|
| | First organic solvent | Organic semiconductor | | Temperature °C | Second organic solvent | Temperature °C | | Uniformity | Film thickness nm | Mobility |
| | Type | Type | Concentration wt% | | Type | | | | | |
| Example 1 | Dichloromethane | TIPS pentacene | 5 | 40 | Dimethylformamide | 25 | Multilayer coating | A | 100 | 0.34 |
| Example 2 | Dichloromethane | TIPS pentacene | 5 | 80 | Dimethylformamide | 25 | Multilayer coating | A | 100 | 0.4 |
| Example 3 | Dichloromethane | TIPS pentacene | 5 | 30 | Dimethylformamide | 25 | Multilayer coating | B | 100 | 0.1 |
| Example 4 | Dichloromethane | TIPS pentacene | 5 | 40 | Dimethylformamide | 60 | Multilayer coating | B | 100 | 0.1 |
| Example 5 | Toluene | C8-BTBT | 5 | 40 | MEK | 25 | Multilayer coating | C | 100 | 0.05 |
| Comparative Example 1 | Dichloromethane | TIPS pentacene | 5 | 40 | Dimethylformamide | 25 | Individual coating | E | 100 | 0.001 |
| Comparative Example 2 | Dichloromethane | TIPS pentacene | 5 | 40 | Dichloromethane | 25 | Multilayer coating | E | 100 | 0.001 |
| Example 6 | Dichloromethane | TIPS pentacene | 5 | 40 | Dimethylformamide | 25 | Slide coating | C | 100 | 0.03 |

From Table 1, it can be seen that the organic semiconductor thin film produced by the method for manufacturing an organic semiconductor thin film of the embodiment of the present invention has higher uniformity than the organic semiconductor thin film produced in Comparative Examples and high mobility can be obtained in a case of being used in the organic thin film transistor.

In addition, from the comparison with Examples 1 to 4, it can be seen that the temperature of the first coating liquid is preferably higher than the temperature of the second coating liquid, and the temperature of the first coating liquid is preferably 15°C or higher.

In addition, from Examples 1 and 6, it can be seen that the coating method may be simultaneous multilayer coating or multilayer slide bead coating, but simultaneous multilayer coating is preferable.

From the above results, the effect of the present invention is clear.


Explanation of References

10: organic semiconductor thin film manufacturing apparatus
11: second coating liquid
12: coating film of second coating liquid
13: first coating liquid
14: coating film of first coating liquid
16: substrate
16R: substrate roll
18: coating film
20, 22, 68, 69: slot
24: bead of first coating liquid
25: first coating liquid on slide surface
26: bead of second coating liquid
27: second coating liquid on slide surface
28: slot die
30: cover
32, 34, 36, 62, 64, 66: block
32a, 34a, 36a: lip surface
32b, 36b: temperature adjusting hole
50: rotary shaft
51: coating portion
52: drying portion
54: winding shaft
56: backup roller
58, 60: tension roller
70: slide hopper


**Claims**

1.  A method for manufacturing an organic semiconductor thin film, comprising:

    a preparation step of preparing a first coating liquid (13) in which an organic semiconductor is dissolved in a first organic solvent and a second coating liquid (11) containing a second organic solvent having a lower affinity for the organic semiconductor than that of the first organic solvent;
    a coating step of applying the first coating liquid (13) and the second coating liquid (11) on a substrate (16) in an overlapping manner such that a coating film (12) of the second coating liquid (11) is formed on the substrate (16) and a coating film (14) of the first coating liquid (13) is formed on the coating film (12) of the second coating liquid (11);
    a drying step of drying a coating film (18) of the first coating liquid (13) and the second coating liquid (11) applied on the substrate (16) in the coating step after the organic semiconductor is precipitated from the coating film (18),
    **characterized in that**
    the affinity of the first organic solvent is expressed by a solubility of the first organic solvent with respect to the organic semiconductor, the affinity of the second organic solvent is expressed by a solubility of the second organic solvent with respect to the organic semiconductor,
the solubility of the first organic solvent with respect to the organic semiconductor is 0.01wt% or more, and the solubility of the second organic solvent with respect to the organic semiconductor is 0.001wt% or less, and in the coating step, the second coating liquid (11) is in contact with the first coating liquid (13) during a period from jetting of the second coating liquid (11) to application of the second coating liquid (11) on the substrate (16).

2. The method for manufacturing an organic semiconductor thin film according to claim 1, wherein a contact angle of the second coating liquid (11) with respect to the substrate (16) is smaller than a contact angle of the first coating liquid (13) with respect to the substrate (16).

3. The method for manufacturing an organic semiconductor thin film according to claim 1 or 2, wherein, in the coating step, a temperature of the first coating liquid (13) is higher than a temperature of the second coating liquid (11).

4. The method for manufacturing an organic semiconductor thin film according to claim 3, wherein, in the coating step, a temperature of a lip portion (36a) that jets the first coating liquid (13) is higher than a temperature of a lip portion (32a) that jets the second coating liquid (11).

5. The method for manufacturing an organic semiconductor thin film according to claim 4, wherein at least a part of a member between a slot (22) that jets the first coating liquid (13) and a slot (20) that jets the second coating liquid (11) consists of plastic.

6. The method for manufacturing an organic semiconductor thin film according to any one of claims 1 to 5, wherein, in the coating step, a temperature of the substrate (16) is lower than a temperature of the second coating liquid (11).

7. The method for manufacturing an organic semiconductor thin film according to any one of claims 1 to 6, wherein a ratio of a jetting amount of the first coating liquid (13) to a jetting amount of the second coating liquid (11) in the coating step is 1:0.01 to 1:100.

8. The method for manufacturing an organic semiconductor thin film according to any one of claims 1 to 7, wherein a viscosity of each of the first coating liquid (13) and the second coating liquid (11) in the coating step is 0.0005 Pa·s to 0.05 Pa·s.

9. The method for manufacturing an organic semiconductor thin film according to any one of claims 1 to 8, wherein

the substrate (16) has a long shape, and
the coating step and the drying step are performed while the substrate (16) is transported in a longitudinal direction.

10. The method for manufacturing an organic semiconductor thin film according to claim 9, wherein a transport speed of the substrate is 0.01 m/s to 10 m/s.


**Patentansprüche**

1. Verfahren zur Herstellung einer organischen Halbleiterdünnschicht, umfassend:

einen Herstellungsschritt der Herstellung einer ersten Beschichtungsflüssigkeit (13), in der ein organischer Halbleiter in einem ersten organischen Lösungsmittel und einer zweiten Beschichtungsflüssigkeit (11) enthaltend ein zweites organisches Lösungsmittel mit einer geringeren Affinität für den organischen Halbleiter als die des ersten organischen Lösungsmittels, gelöst wird;
einen Beschichtungsschritt des Auftragens der ersten Beschichtungsflüssigkeit (13) und der zweiten Beschichtungsflüssigkeit (11) auf ein Substrat (16) in einer überlappenden Weise, so dass ein Beschichtungsfilm (12) der zweiten Beschichtungsflüssigkeit (11) auf dem Substrat (16) gebildet wird und ein Beschichtungsfilm (14) der ersten Beschichtungsflüssigkeit (13) auf dem Beschichtungsfilm (12) der zweiten Beschichtungsflüssigkeit (11) gebildet wird; und
einen Trocknungsschritt des Trocknens eines Beschichtungsfilms (18) aus der in dem Beschichtungsschritt, nachdem der organische Halbleiter aus dem Beschichtungsfilm (18) ausgefällt wurde, auf das Substrat (16) aufgebrachten ersten Beschichtungsflüssigkeit (13) und der zweiten Beschichtungsflüssigkeit (11),

**dadurch gekennzeichnet, dass**

die Affinität des ersten organischen Lösungsmittels durch eine Löslichkeit des ersten organischen Lösungsmittels in Bezug auf den organischen Halbleiter ausgedrückt wird,

die Affinität des zweiten organischen Lösungsmittels durch eine Löslichkeit des zweiten organischen Lösungsmittels in Bezug auf den organischen Halbleiter ausgedrückt wird,

die Löslichkeit des ersten organischen Lösungsmittels in Bezug auf den organischen Halbleiter 0,01 Gew.-% oder mehr beträgt und die Löslichkeit des zweiten organischen Lösungsmittels in Bezug auf den organischen Halbleiter 0,001 Gew.-% oder weniger beträgt, und

in dem Beschichtungsschritt die zweite Beschichtungsflüssigkeit (11) mit der ersten Beschichtungsflüssigkeit (13) während eines Zeitraums vom Ausstoßen der zweiten Beschichtungsflüssigkeit (11) bis zum Aufbringen der zweiten Beschichtungsflüssigkeit (11) auf das Substrat (16) in Kontakt ist.

2. Verfahren zur Herstellung einer organischen Halbleiterdünnschicht nach Anspruch 1, wobei ein Kontaktwinkel der zweiten Beschichtungsflüssigkeit (11) in Bezug auf das Substrat (16) kleiner ist als ein Kontaktwinkel der ersten Beschichtungsflüssigkeit (13) in Bezug auf das Substrat (16).

3. Verfahren zur Herstellung einer organischen Halbleiterdünnschicht nach Anspruch 1 oder 2, wobei, in dem Beschichtungsschritt, eine Temperatur der ersten Beschichtungsflüssigkeit (13) höher ist als eine Temperatur der zweiten Beschichtungsflüssigkeit (11).

4. Verfahren zur Herstellung einer organischen Halbleiterdünnschicht nach Anspruch 3, wobei, in dem Beschichtungsschritt, eine Temperatur eines Lippenabschnitts (36a), der die erste Beschichtungsflüssigkeit (13) ausstößt, höher ist als eine Temperatur eines Lippenabschnitts (32a), der die zweite Beschichtungsflüssigkeit (11) ausstößt.

5. Verfahren zur Herstellung einer organischen Halbleiterdünnschicht nach Anspruch 4, wobei zumindest ein Teil eines Elements zwischen einem Schlitz (22), der die erste Beschichtungsflüssigkeit (13) ausstößt, und einem Schlitz (20), der die zweite Beschichtungsflüssigkeit (11) ausstößt, aus Kunststoff besteht.

6. Verfahren zur Herstellung einer organischen Halbleiterdünnschicht nach einem der Ansprüche 1 bis 5, wobei, in dem Beschichtungsschritt, eine Temperatur des Substrats (16) niedriger ist als eine Temperatur der zweiten Beschichtungsflüssigkeit (11).

7. Verfahren zur Herstellung einer organischen Halbleiterdünnschicht nach einem der Ansprüche 1 bis 6, wobei das Verhältnis einer Ausstoßmenge der ersten Beschichtungsflüssigkeit (13) zu einer Ausstoßmenge der zweiten Beschichtungsflüssigkeit (11) im Beschichtungsschritt 1:0,01 bis 1:100 beträgt.

8. Verfahren zur Herstellung einer organischen Halbleiterdünnschicht nach einem der Ansprüche 1 bis 7, wobei eine Viskosität von jeder der ersten Beschichtungsflüssigkeit (13) und der zweiten Beschichtungsflüssigkeit (11) in dem Beschichtungsschritt jeweils 0,0005 Pa s bis 0,05 Pa s beträgt.

9. Verfahren zur Herstellung einer organischen Halbleiterdünnschicht nach einem der Ansprüche 1 bis 8, wobei

das Substrat (16) eine längliche Form hat, und

der Beschichtungsschritt und der Trocknungsschritt durchgeführt werden, während das Substrat (16) in einer Längsrichtung transportiert wird.

10. Verfahren zur Herstellung einer organischen Halbleiterdünnschicht nach Anspruch 9, wobei eine Transportgeschwindigkeit des Substrats 0,01 m/s bis 10 m/s beträgt.

## Revendications

1. Procédé de fabrication d'une couche mince de semi-conducteur organique, comprenant :

une étape de préparation consistant à préparer un premier liquide de revêtement (13) dans lequel un semi-conducteur organique est dissous dans un premier solvant organique et un second liquide de revêtement (11) contenant un second solvant organique ayant une affinité plus faible pour le semi-conducteur organique que celle du premier solvant organique ;

une étape de revêtement consistant à appliquer le premier liquide de revêtement (13) et le second liquide de revêtement (11) sur un substrat (16) de manière superposée de sorte qu'une couche de revêtement (12) du second liquide de revêtement (11) soit formée sur le substrat (16) et qu'une couche de revêtement (14) du premier liquide de revêtement (13) soit formée sur la couche de revêtement (12) du second liquide de revêtement (11) ; et

une étape de séchage consistant à sécher une couche de revêtement (18) du premier liquide de revêtement (13) et du second liquide de revêtement (11) appliquée sur le substrat (16) lors de l'étape de revêtement après que le semi-conducteur organique a été précipité à partir de la couche de revêtement (18),

**caractérisé en ce que**

l'affinité du premier solvant organique est exprimée par une solubilité du premier solvant organique par rapport au semi-conducteur organique, l'affinité du second solvant organique est exprimée par une solubilité du second solvant organique par rapport au semi-conducteur organique,

la solubilité du premier solvant organique par rapport au semi-conducteur organique est égale ou supérieure à 0,01 % en poids, et la solubilité du second solvant organique par rapport au semi-conducteur organique est égale ou inférieure à 0,001 % en poids, et

lors de l'étape de revêtement, le second liquide de revêtement (11) est en contact avec le premier liquide de revêtement (13) pendant une période allant de la projection du second liquide de revêtement (11) à l'application du second liquide de revêtement (11) sur le substrat (16).

2. Procédé de fabrication d'une couche mince de semi-conducteur organique selon la revendication 1, dans lequel un angle de contact du second liquide de revêtement (11) par rapport au substrat (16) est plus petit qu'un angle de contact du premier liquide de revêtement (13) par rapport au substrat (16).

3. Procédé de fabrication d'une couche mince de semi-conducteur organique selon la revendication 1 ou 2, dans lequel, lors de l'étape de revêtement, une température du premier liquide de revêtement (13) est plus élevée qu'une température du second liquide de revêtement (11).

4. Procédé de fabrication d'une couche mince de semi-conducteur organique selon la revendication 3, dans lequel, lors de l'étape de revêtement, une température d'une partie formant lèvre (36a) qui projette le premier liquide de revêtement (13) est supérieure à une température d'une partie formant lèvre (32a) qui projette le second liquide de revêtement (11).

5. Procédé de fabrication d'une couche mince de semi-conducteur organique selon la revendication 4, dans lequel au moins une partie d'un élément situé entre une fente (22) qui projette le premier liquide de revêtement (13) et une fente (20) qui projette le second liquide de revêtement (11) est constituée de plastique.

6. Procédé de fabrication d'une couche mince de semi-conducteur organique selon l'une quelconque des revendications 1 à 5, dans lequel, lors de l'étape de revêtement, une température du substrat (16) est inférieure à une température du second liquide de revêtement (11).

7. Procédé de fabrication d'une couche mince de semi-conducteur organique selon l'une quelconque des revendications 1 à 6, dans lequel un rapport entre une quantité de projection du premier liquide de revêtement (13) et une quantité de projection du second liquide de revêtement (11) lors de l'étape de revêtement est compris entre 1:0,01 et 1:100.

8. Procédé de fabrication d'une couche mince de semi-conducteur organique selon l'une quelconque des revendications 1 à 7, dans lequel une viscosité du premier liquide de revêtement (13) et du second liquide de revêtement (11) lors de l'étape de revêtement est comprise entre 0,0005 Pa-s et 0,05 Pa·s.

9. Procédé de fabrication d'une couche mince de semi-conducteur organique selon l'une quelconque des revendications 1 à 8, dans lequel

le substrat (16) a une forme allongée, et
l'étape de revêtement et l'étape de séchage sont effectuées pendant que le substrat (16) est transporté dans une direction longitudinale.

10. Procédé de fabrication d'une couche mince de semi-conducteur organique selon la revendication 9, dans lequel une vitesse de transport du substrat est comprise entre 0,01 m/s et 10 m/s.

# FIG. 1

# FIG. 2

# FIG. 3

# FIG. 4

# FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012043926 A
- WO 2012023476 A
- JP 2012049291 A
- JP 2015170760 A
- JP 2015195361 A
- JP 2018006745 A